# EUROPEAN PATENT APPLICATION

(11) **EP 4 848 581 A1**
(43) Date of publication of application: **02.12.2026**
(21) Application number: 24920369.6
(22) Date of filing: 22.01.2024
(51) Int. Cl.: H03F 1/34, H03F 3/45

(54) **NON-INVERTING AMPLIFIER CIRCUIT**

(71) Applicant: Hioki E.E. Corporation, Ueda-shi, Nagano 386-1192 (JP)
(72) Inventor: KARASAWA, Yuki, Ueda-shi Nagano 386-1192 (JP); XIA, Peiyu, Ueda-shi Nagano 386-1192 (JP); NAKAZAWA, Koki, Ueda-shi Nagano 386-1192 (JP); IKEDA, Kenta, Ueda-shi Nagano 386-1192 (JP)
(74) Representative: Novagraaf International SA
(86) International application number: PCT/JP2024/001553
(87) International publication number: WO 2025/158477

(57) **Abstract**

To provide a non-inverting amplifier circuit capable of sufficiently improving low-frequency characteristics. The non-inverting amplifier circuit is a non-inverting amplifier circuit 1A that amplifies, in a non-inverting manner, an input signal SINA input to a signal input part ISA by a gain of 1 and outputs the amplified signal from a signal output part OSA as an output signal SOUTA, and includes operational amplifiers OP1A and OP2A. The operational amplifier OP1A has a configuration in which an inverting input terminal is connected to the signal input part ISA, an inverting input terminal is connected to an output terminal via a resistor R1A, and the output terminal is connected to the signal output part OSA, and the operational amplifier OP2A has a configuration in which a non-inverting input terminal is connected to the output terminal of the operational amplifier OP1A, an inverting input terminal is connected to the signal input part ISA, and the output terminal is connected to the inverting input terminal of the operational amplifier OP1A via a resistor R2A.

## Description

### TECHNICAL FIELD

The present invention relates to a non-inverting amplifier circuit for amplifying, in a non-inverting manner, an input signal input to a signal input part with a predetermined gain and outputting the amplified signal from a signal output part as an output signal.

### BACKGROUND ART

As this type of non-inverting amplifier circuit, a non-inverting amplifier circuit disclosed in Non-Patent Document below is known. The non-inverting amplifier circuit has a configuration in which an inverting input terminal of an operational amplifier is connected to an output terminal, and operates as a so-called unity gain buffer that amplifies, in a non-inverting manner, an input signal input to a non-inverting input terminal by a gain of 1 and outputs the amplified signal from the output terminal as an output signal.

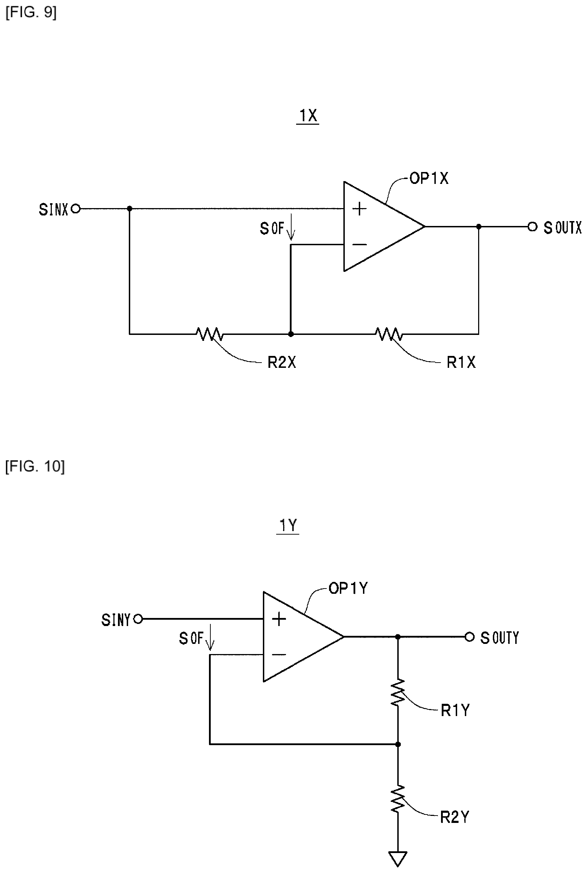

In addition, as a non-inverting amplifier circuit that operates as a unity gain buffer, a non-inverting amplifier circuit 1X illustrated in FIG. 9 is also known. The non-inverting amplifier circuit 1X includes an operational amplifier OP1X, and has a configuration in which an inverting input terminal of the operational amplifier OP1X is connected to an output terminal via a resistor R1X and also connected to a non-inverting input terminal via a resistor R2X. The non-inverting amplifier circuit 1X amplifies, in a non-inverting manner, an input signal SINX input to the non-inverting input terminal of the operational amplifier OP1X and outputs the amplified signal from the output terminal as an output signal SOUTX. In this case, the non-inverting amplifier circuit 1X operates to satisfy the following relationship when a resistance value of the resistor R1X is R1X, a resistance value of the resistor R2X is R2X, a voltage value of the input signal SINX is VINX, and a voltage value of the output signal SOUTX is VOUTX. $VOUTX = VINX$

In addition, as another non-inverting amplifier circuit, a non-inverting amplifier circuit disclosed in Non-Patent Document below is also known in the related art. As illustrated in FIG. 10, a non-inverting amplifier circuit 1Y includes an operational amplifier OP1Y, and has a configuration in which an inverting input terminal of the operational amplifier OP1Y is connected to an output terminal via a resistor R1Y and also connected to a ground potential via a resistor R2Y. The non-inverting amplifier circuit 1Y amplifies, in a non-inverting manner, an input signal SINY input to a non-inverting input terminal of the operational amplifier OP1Y and outputs the amplified signal from the output terminal as an output signal SOUTY. In this case, the non-inverting amplifier circuit 1Y operates to satisfy the following relationship when a resistance value of the resistor R1Y is R1Y, a resistance value of the resistor R2Y is R2Y, a voltage value of the input signal SINY is VINY, and a voltage value of the output signal SOUTY is VOUTY. $VOUTY = \left(\left(R1Y+R2Y\right)/R2Y\right) \times VINY$

### CITATION LIST

### PATENT LITERATURE

Patent Document 1: JP 2017-20963 A (Pages 6 to 16, FIG. 1)

### NON-PATENT LITERATURE

Non-Patent Document 1: Hideo Kakuda, Practical Operational Amplifier Circuit, Tokyo Denki University Press, February 1997

### SUMMARY OF INVENTION

### TECHNICAL PROBLEM

However, the non-inverting amplifier circuits in the related art can easily be configured to have excellent high-frequency characteristics, but have the problem of making it difficult to improve low-frequency characteristics (DC characteristics), such as reduction of an offset voltage generated between the inverting input terminal and the non-inverting input terminal of the operational amplifier and reduction of so-called 1/f noise. Specifically, as illustrated in FIG. 9, in the above non-inverting amplifier circuit 1X, when an offset voltage SOF (voltage value is VOF) is generated between the inverting input terminal and the non-inverting input terminal of the operational amplifier OP1X, the voltage value VOUTX of the output signal SOUTX includes the voltage VOF in the voltage VINX as follows. $VOUTX = VINX + VOF$

In addition, as illustrated in FIG. 10, in the above non-inverting amplifier circuit 1Y, when an offset voltage SOF (voltage value is VOF) is generated between the inverting input terminal and the non-inverting input terminal of the operational amplifier OP1Y, the voltage value VOUTY of the output signal SOUTY includes the voltage VOF in the voltage VINY as follows. $VOUTY = \left(\left(R1Y+R2Y\right)/R2Y\right) \times \left(VINY+VOF\right)$

The present invention has been made in view of the above problems, and a main object of the present invention is to provide a non-inverting amplifier circuit capable of sufficiently improving low-frequency characteristics.

### SOLUTION TO PROBLEM

In order to achieve the above object, a non-inverting amplifier circuit according to the present invention is a non-inverting amplifier circuit that amplifies, in a non-inverting manner, an input signal input to a signal input part by a gain of 1 and outputs the amplified signal from a signal output part as an output signal and includes a 1A operational amplifier and a 2A operational amplifier, wherein the 1A operational amplifier has a configuration in which a non-inverting input terminal is connected to the signal input part, an inverting input terminal is connected to an output terminal via a 1A resistor, and the output terminal is connected to the signal output part, and the 2A operational amplifier has a configuration in which a non-inverting input terminal is connected to the output terminal of the 1A operational amplifier, an inverting input terminal is connected to the signal input part, and an output terminal is connected to the inverting input terminal of the 1A operational amplifier via a 2A resistor.

According to the non-inverting amplifier circuit, even when an offset voltage or 1/f noise is generated in the 1A operational amplifier, the offset voltage or the 1/f noise can be sufficiently removed and the resulting signal can be output as an output signal.

In order to achieve the above object, a non-inverting amplifier circuit according to the present invention is a non-inverting amplifier circuit that amplifies, in a non-inverting manner, an input signal input to a signal input part by a gain of 1 and outputs the amplified signal from a signal output part as an output signal and includes a 1A operational amplifier and a 2A operational amplifier, wherein the 1A operational amplifier has a configuration in which a non-inverting input terminal is connected to the signal input part, an inverting input terminal is connected to an output terminal via a 1A resistor, and the output terminal is connected to the signal output part, the 2A operational amplifier has a configuration in which a non-inverting input terminal is connected to the output terminal of the 1A operational amplifier, an inverting input terminal is connected to the signal input part via a 3A resistor and connected to an output terminal via a 1A capacitor, and the output terminal is connected to the inverting input terminal of the 1A operational amplifier via a 2A resistor, the 2A resistor is configured by a series circuit of a 4A resistor connected to the inverting input terminal of the 1A operational amplifier and a 5A resistor connected to the output terminal of the 2A operational amplifier, and a connection point between the 4A resistor and the 5A resistor and the non-inverting input terminal of the 1A operational amplifier are connected to each other by a 2A capacitor.

According to the non-inverting amplifier circuit, since the 1A operational amplifier and the 2A operational amplifier are used to form a composite circuit, even when an offset voltage or 1/f noise is generated in the 1A operational amplifier, the offset voltage or 1/f noise can be sufficiently removed and the resulting signal can be output as an output signal. In addition, the non-inverting amplifier circuit can sufficiently improve low-frequency characteristics (DC characteristics) while maintaining good high-frequency characteristics of the first operational amplifier A.

In order to achieve the above object, a non-inverting amplifier circuit according to the present invention is a non-inverting amplifier circuit that amplifies, in a non-inverting manner, an input signal input to a signal input part with a predetermined gain and outputs the amplified signal from a signal output part as an output signal and includes a 1B operational amplifier and a 2B operational amplifier, wherein the 1B operational amplifier has a configuration in which an inverting input terminal is connected to an output terminal via a 1B resistor and connected to an intermediate potential via a 2B resistor, and the output terminal is connected to the signal output part, and the 2B operational amplifier has a configuration in which a non-inverting input terminal is connected to the signal input part, an inverting input terminal is connected to the inverting input terminal of the 1B operational amplifier, and the output terminal is connected to the non-inverting input terminal of the 1B operational amplifier.

According to the non-inverting amplifier circuit, even when an offset voltage or 1/f noise is generated in the 1B operational amplifier, the offset voltage or the 1/f noise can be sufficiently removed and the resulting signal can be output as an output signal.

In order to achieve the above object, a non-inverting amplifier circuit according to the present invention is a non-inverting amplifier circuit that amplifies, in a non-inverting manner, an input signal input to a signal input part with a predetermined gain and outputs the amplified signal from a signal output part as an output signal and includes a 1B operational amplifier and a 2B operational amplifier, wherein the 1B operational amplifier has a configuration in which a non-inverting input terminal is connected to the signal input part via a 1B capacitor, an inverting input terminal is connected to an output terminal via a 1B resistor and connected to an intermediate potential via a 2B resistor, and the output terminal is connected to the signal output part, and the 2B operational amplifier has a configuration in which a non-inverting input terminal is connected to the signal input part via a 3B resistor, an inverting input terminal is connected to the inverting input terminal of the 1B operational amplifier via a 4B resistor and connected to an output terminal via a 2B capacitor, and an output terminal is connected to the non-inverting input terminal of the 1B operational amplifier via a 5B resistor.

According to the non-inverting amplifier circuit, since the 1B operational amplifier and the 2B operational amplifier are used to form a composite circuit, even when an offset voltage or 1/f noise is generated in the 1B operational amplifier, the offset voltage or 1/f noise can be sufficiently removed and the resulting signal can be output as an output signal. In addition, the non-inverting amplifier circuit can sufficiently improve low-frequency characteristics (DC characteristics) while maintaining good high-frequency characteristics of the 1B operational amplifier.

### ADVANTAGEOUS EFFECTS OF INVENTION

In accordance with the non-inverting amplifier circuit according to the present invention, even when an offset voltage or 1/f noise is generated in the 1A operational amplifier or the 1B operational amplifier, the offset voltage or the 1/f noise can be sufficiently removed and the resulting signal can be output as an output signal.

### BRIEF DESCRIPTION OF DRAWINGS

FIG. 1 is a circuit diagram of a non-inverting amplifier circuit 1A.
FIG. 2 is an equivalent circuit diagram of the non-inverting amplifier circuit 1A when an input signal SINA is a high-frequency signal.
FIG. 3 is a frequency characteristic diagram illustrating frequency characteristics of noise (1/f noise) included in an output signal output from the non-inverting amplifier circuit in the related art disclosed in the above publication.
FIG. 4 is a frequency characteristic diagram illustrating frequency characteristics of noise (1/f noise) included in an output signal SOUTA output from the non-inverting amplifier circuit 1A.
FIG. 5 is a circuit diagram of a non-inverting amplifier circuit 1B.
FIG. 6 is an equivalent circuit diagram of the inverting amplifier circuit 1B when an input signal SINB is a high-frequency signal.
FIG. 7 is a frequency characteristic diagram illustrating frequency characteristics of noise (1/f noise) included in an output signal SOUTY output from a non-inverting amplifier circuit 1Y in the related art.
FIG. 8 is a frequency characteristic diagram illustrating frequency characteristics of noise (1/f noise) included in an output signal SOUTAB output from the non-inverting amplifier circuit 1B.
FIG. 9 is a circuit diagram of a non-inverting amplifier circuit 1X in the related art.
FIG. 10 is a circuit diagram of a non-inverting amplifier circuit 1Y in the related art.

### DESCRIPTION OF EMBODIMENTS

An embodiment of a non-inverting amplifier circuit is described below with reference to the accompanying drawings.

### First Example

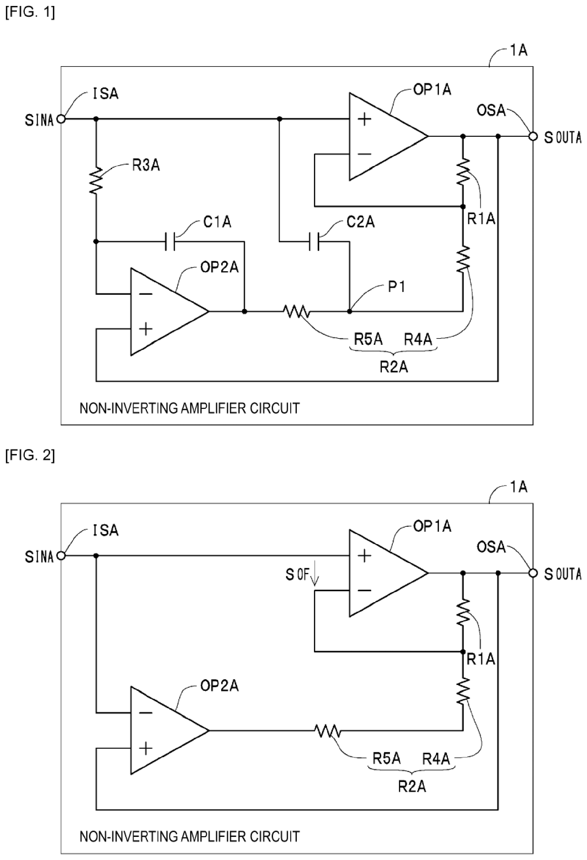

A non-inverting amplifier circuit 1A illustrated in FIG. 1 is a so-called unity gain buffer, and is configured to function as a non-inverting amplifier circuit that amplifies, in a non-inverting manner, an input signal SINA input via a signal input part ISA by a gain of 1 and outputs the amplified signal from a signal output part OSA as an output signal SOUTA.

Specifically, the non-inverting amplifier circuit 1A includes an operational amplifier OP1A functioning as a 1A operational amplifier and having good high-frequency characteristics (for example, good broadband characteristics) and an operational amplifier OP2A functioning as a 2A operational amplifier and having good low-frequency characteristics. In addition, each of the operational amplifiers OP1A and OP2A, for example, operates using, as power supply voltages, a positive voltage and a negative voltage having absolute values equal to each other with respect to a ground potential as an intermediate potential.

In this case, the operational amplifier OP1A has a configuration in which a non-inverting input terminal (1A non-inverting input terminal) is connected to the signal input part ISA, an inverting input terminal (1A inverting input terminal) is connected to an output terminal (1A output terminal) via a resistor R1A (1A resistor), and the output terminal is connected to the signal output part OSA. The operational amplifier OP2A has a configuration in which a non-inverting input terminal (2A non-inverting input terminal) is connected to the output terminal of the operational amplifier OP1A, an inverting input terminal (2A inverting input terminal) is connected to the signal input part ISA via a resistor R3A (3A resistor) and connected to an output terminal via a capacitor C1A (1A capacitor), and the output terminal (2A output terminal) is connected to the inverting input terminal of the operational amplifier OP1A via a resistor R2A (2A resistor). In this case, the resistor R2A is configured by a series circuit of a resistor R4A (4A resistor) connected to the inverting input terminal of the operational amplifier OP1A and a resistor R5A (R5A resistor) connected to the output terminal of the operational amplifier OP2A, and a connection point P1 between the resistor R4A and the resistor R5A and the non-inverting input terminal of the operational amplifier OP1A are connected to each other by a capacitor C2A (2A capacitor).

The operation of the non-inverting amplifier circuit 1A is described below.

First, the operation of the non-inverting amplifier circuit 1A when the input signal SINA is a DC signal or a signal having a sufficiently low frequency (hereinafter, both are also collectively referred to as "DC signals") is described. When the input signal SINA is a DC signal, since the impedances of the capacitors C1A and C2A become extremely large and the resistance value of the resistor R3A is negligible, the non-inverting amplifier circuit 1A equivalently has a circuit configuration in which the inverting input terminal of the operational amplifier OP2A is directly connected to the signal input part ISA, the inverting input terminal and the output terminal are open, and the connection point P1 and the non-inverting input terminal of the operational amplifier OP1A are open.

Accordingly, when the input signal SINA is a DC signal, the non-inverting amplifier circuit 1A is represented by the circuit configuration illustrated in FIG. 2. Therefore, in the non-inverting amplifier circuit 1A, the operational amplifier OP1A has a configuration in which the non-inverting input terminal is connected to the signal input part ISA, the inverting input terminal is connected to the output terminal via the resistor R1A, and the output terminal is connected to the signal output part OSA. The operational amplifier OP2A has a configuration in which the non-inverting input terminal is connected to the output terminal of the operational amplifier OP1A, the inverting input terminal is directly connected to the signal input part ISA, and the output terminal is connected to the inverting input terminal of the operational amplifier OP1A via the resistor R2A.

In this circuit configuration, when an open gain of the operational amplifier OP2A is A, a resistance value of the resistor R1A is R1A, a resistance value of the resistor R2A (the series circuit of the resistor R4A and the resistor R5A) is R2A, a voltage value of the input signal SINA is VINA, a voltage value of the output signal SOUTA is VOUTA, and a voltage value of an offset voltage SOF generated between the inverting input terminal and the non-inverting input terminal of the operational amplifier OP1A is VOF, the following Equation (1) is derived. 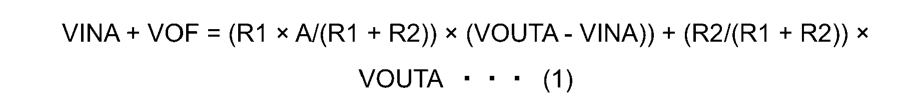 VINA + VOF = (R1 × A/(R1 + R2)) × (VOUTA - VINA)) + (R2/(R1 + R2)) × VOUTA ••• (1)

Accordingly, the voltage value VOUTA of the output signal SOUTA is expressed by the following Equation (2). 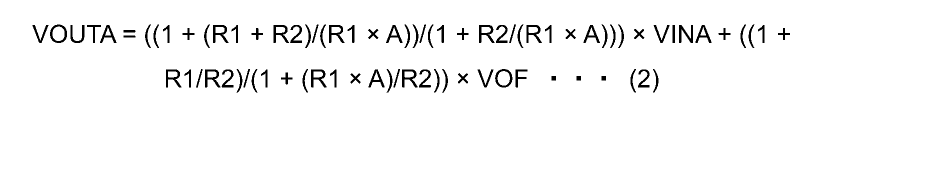 VOUTA = ((1 + (R1 + R2)/(R1 × A))/(1 + R2/(R1 × A))) × VINA + ((1 + R1/R2)/(1 + (R1 × A)/R2)) × VOF ••• (2)

When the open gain A of the operational amplifier OP2A is sufficiently large, the voltage value VOUTA of the output signal SOUTA is expressed by the following Equation (3). $VOUTA = VINA$ (3)

That is, in the non-inverting amplifier circuit 1A, even when the offset voltage SOF or the 1/f noise is generated in the operational amplifier OP1A, a unity gain buffer capable of outputting the output signal SOUTA not including the offset voltage SOF or the 1/f noise can be configured.

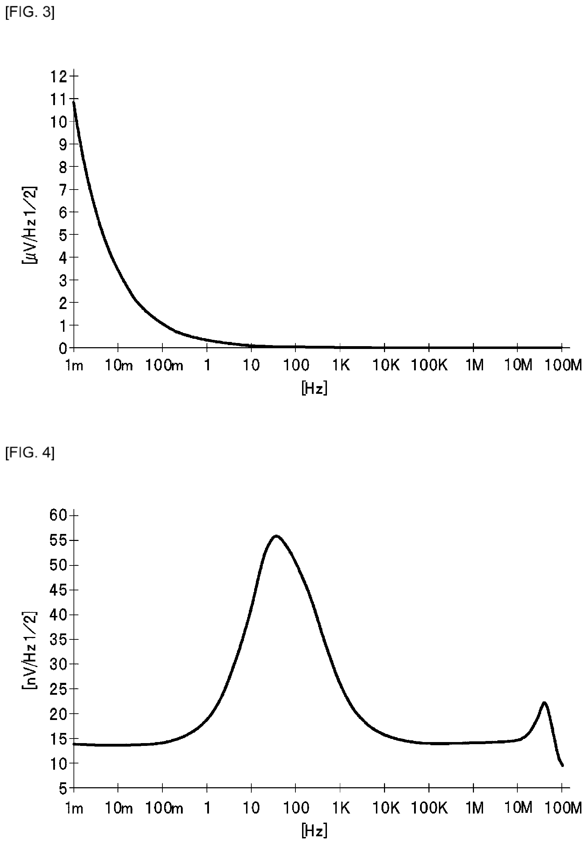

As illustrated in FIG. 3, in the output signal output from the non-inverting amplifier circuit in the related art disclosed in the above publication, noise considered to be 1/f noise is superimposed at a high level in a low-frequency region including a DC signal. In contrast, as illustrated in FIG. 4, in the output signal SOUTA output from the non-inverting amplifier circuit 1A, noise considered to be the 1/f noise is sufficiently reduced in the low-frequency region including the DC signal.

The operation of the non-inverting amplifier circuit 1A when the input signal SINA is a high-frequency signal is described below with reference to FIG. 1.

When the input signal SINA is a high-frequency signal, the impedances of the capacitors C1A and C2A are sufficiently small. Therefore, in the non-inverting amplifier circuit 1A, the connection point P1 and the non-inverting input terminal of the operational amplifier OP1A are short-circuited, and the operational amplifier OP2A does not function. Specifically, in the non-inverting amplifier circuit 1A, the operational amplifier OP1A has a configuration in which the non-inverting input terminal is directly connected to the signal input part ISA, the inverting input terminal is connected to the non-inverting input terminal via the resistor R4A and directly connected to the output terminal via the resistor R1A, and the output terminal is connected to the signal output part OSA. That is, in this configuration, the non-inverting amplifier circuit 1A is equivalent in circuit configuration to the above non-inverting amplifier circuit 1X illustrated in FIG. 9. Accordingly, the non-inverting amplifier circuit 1A maintains the high-frequency characteristics of the operational amplifier OP1A having good high-frequency characteristics.

In this way, according to the non-inverting amplifier circuit 1A, since the two operational amplifiers OP1A and OP2A are used to form a composite circuit, even when the offset voltage SOF or the 1/f noise is generated in the operational amplifier OP1A, the offset voltage SOF or the 1/f noise can be sufficiently removed and the resulting signal can be output as the output signal SOUTA. In addition, the non-inverting amplifier circuit 1A can sufficiently improve low-frequency characteristics (DC characteristics) while maintaining good high-frequency characteristics of the operational amplifier OP1A.

### Second Example

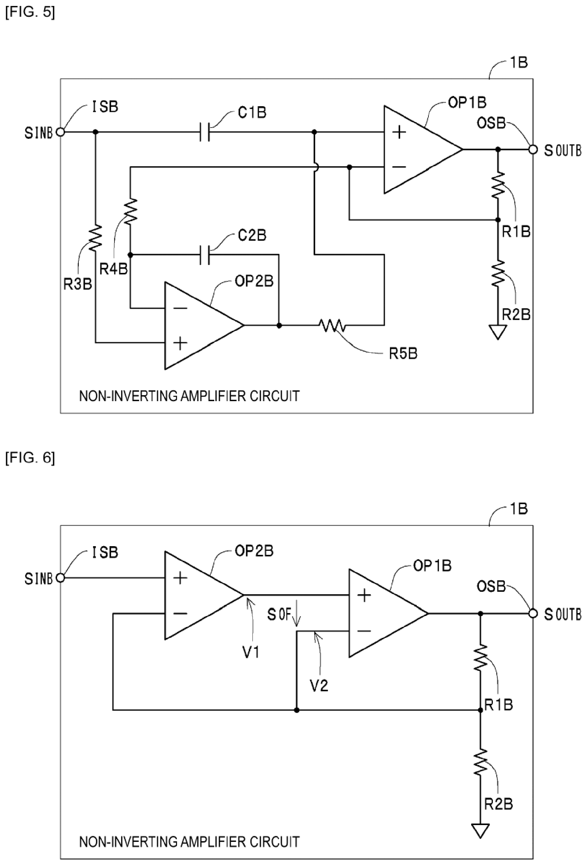

A non-inverting amplifier circuit 1B illustrated in FIG. 5 is configured to function as a non-inverting amplifier circuit that amplifies, in a non-inverting manner, an input signal SINB input via a signal input part ISB with a predetermined gain and outputs the amplified signal from a signal output part OSB as an output signal SOUTB.

Specifically, the non-inverting amplifier circuit 1B includes an operational amplifier OP1B functioning as a 1B operational amplifier and having good high-frequency characteristics (for example, good broadband characteristics) and an operational amplifier OP2B functioning as a 2B operational amplifier and having good low-frequency characteristics. In addition, each of the operational amplifiers OP1B and OP2B, for example, operates using, as power supply voltages, a positive voltage and a negative voltage having absolute values equal to each other with respect to a ground potential as an intermediate potential.

In this case, the operational amplifier OP1B has a configuration in which a non-inverting input terminal (1B non-inverting input terminal) is connected to the signal input part ISB via a capacitor C1B (1B capacitor), an inverting input terminal (1B inverting input terminal) is connected to an output terminal (1B output terminal) via a resistor R1B (1B resistor) and connected to the intermediate potential via a resistor R2B (2B resistor), and the output terminal (1B output terminal) is connected to the signal output part OSB. The operational amplifier OP2B has a configuration in which a non-inverting input terminal (2B non-inverting input terminal) is connected to the signal input part ISB via a resistor R3B (3B resistor), an inverting input terminal (2B inverting input terminal) is connected to the inverting input terminal of the operational amplifier OP1B via a resistor R4B (4B resistor) and connected to an output terminal (2B output terminal) via a capacitor C2B (2B capacitor), and the output terminal (2B output terminal) is connected to the non-inverting input terminal of the operational amplifier OP1B via a resistor R5B (5B resistor).

The operation of the non-inverting amplifier circuit 1B is described below.

First, the operation of the non-inverting amplifier circuit 1B when the input signal SINB is a DC signal is described. When the input signal SINB is a DC signal, since the impedances of the capacitors C1B and C2B become extremely large and the resistance values of the resistors R3B, R4b, and R5B are negligible, the non-inverting amplifier circuit 1B equivalently has a circuit configuration in which the non-inverting input terminal of the operational amplifier OP1B is open from the signal input part ISB and directly connected to the output terminal of the operational amplifier OP2B, the non-inverting input terminal of the operational amplifier OP2B is directly connected to the signal input part ISB, the inverting input terminal of the operational amplifier OP2B is directly connected to the inverting input terminal of the operational amplifier OP1B, and the output terminal of the operational amplifier OP2B is directly connected to the non-inverting input terminal of the operational amplifier OP1B.

Accordingly, when the input signal SINA is a DC signal, the non-inverting amplifier circuit 1B is represented by the circuit configuration illustrated in FIG. 6. Therefore, in the non-inverting amplifier circuit 1B, the operational amplifier OP1B has a configuration in which the inverting input terminal is connected to the output terminal via the resistor R1B and connected to the intermediate potential via the resistor R2B and the output terminal is connected to the signal output part OSB. In addition, in the non-inverting amplifier circuit 1B, the operational amplifier OP2B has a configuration in which the non-inverting input terminal is connected to the signal input part ISB, the inverting input terminal is connected to the inverting input terminal of the operational amplifier OP1B, and the output terminal is connected to the non-inverting input terminal of the operational amplifier OP1B.

In this circuit configuration, when an open gain of the operational amplifier OP2B is A, a resistance value of the resistor R1B is R1B, a resistance value of the resistor R2B is R2B, a voltage value of the input signal SINB is VINB, a voltage value of the output signal SOUTB is VOUTB, a voltage value of the offset voltage SOF generated between the inverting input terminal and the non-inverting input terminal of the operational amplifier OP1B is VOF, a voltage value of the output terminal of the operational amplifier OP2B is V1, and a voltage value of the inverting input terminal of the operational amplifier OP1B is V2, the following Equation (4) is derived. $V 1 = V 2 - VOF = \left(VINB-V2\right) \times A$ (4)

Accordingly, the following Equation (5) is derived from the Equation (4) above. $\left(1+A\right) \times V 2 = VINB \times A + VOF$ (5)

The voltage value V2 is expressed by the following Equation (6). $V 2 = \left(R2/\left(R1+R2\right)\right) \times VOUTB$ (6)

Accordingly, the voltage value VOUTB of the output signal SOUTB is expressed by the following Equation (7) from Equations (5) and (6) above. 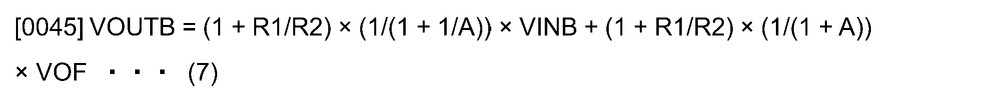 VOUTB = (1 + R1/R2) × (1/(1 + 1/A)) × VINB + (1 + R1/R2) × (1/(1 + A)) × VOF ••• (7)

When the open loop gain A of the operational amplifier OP2B is sufficiently large, the voltage value VOUTB of the output signal SOUTB is expressed by the following Equation (8). $VOUTB = \left(\left(R1+R2\right)/R2\right) \times VINB$ (8)

That is, in the non-inverting amplifier circuit 1B, even when the offset voltage SOF or the 1/f noise is generated in the operational amplifier OP1B, a non-inverting amplifier circuit capable of outputting the output signal SOUTB not including the offset voltage SOF or the 1/f noise can be configured.

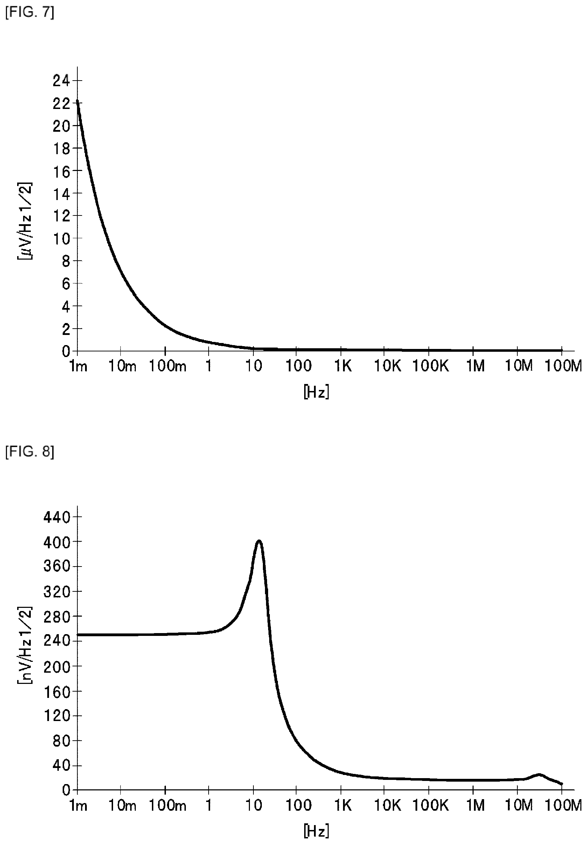

As illustrated in FIG. 7, in the output signal SOUTY output from the inverting amplifier circuit 1Y in the related art, noise considered to be 1/f noise is superimposed at a high level in a low-frequency region including a DC signal. In contrast, as illustrated in FIG. 8, in the output signal SOUTB output from the non-inverting amplifier circuit 1B, noise considered to be the 1/f noise is sufficiently reduced in the low-frequency region including the DC signal.

The operation of the non-inverting amplifier circuit 1B when the input signal SINB is a high-frequency signal is described below with reference to FIG. 5.

When the input signal SINA is a high-frequency signal, the impedances of the capacitors C1B and C2B are sufficiently small. Therefore, in the non-inverting amplifier circuit 1B, the signal input part ISB and the non-inverting input terminal of the operational amplifier OP1B are short-circuited, and the operational amplifier OP2B does not function. Specifically, in the non-inverting amplifier circuit 1B, the operational amplifier OP1B has a configuration in which the non-inverting input terminal is directly connected to the signal input part ISA, the inverting input terminal is connected to the output terminal via the resistor R1A and connected to the intermediate potential via the resistor R2B, and the output terminal is connected to the signal output part OSA. That is, in this configuration, the non-inverting amplifier circuit 1B is equivalent in circuit configuration to the above non-inverting amplifier circuit 1Y illustrated in FIG. 10. Accordingly, the non-inverting amplifier circuit 1B maintains the high-frequency characteristics of the operational amplifier OP1B having good high-frequency characteristics.

In this way, according to the non-inverting amplifier circuit 1B, since the two operational amplifiers OP1B and OP2B are used to form a composite circuit, even when the offset voltage SOF or the 1/f noise is generated in the operational amplifier OP1B, the offset voltage SOF or the 1/f noise can be sufficiently removed and the resulting signal can be output as the output signal SOUTB. In addition, the non-inverting amplifier circuit 1B can sufficiently improve the low-frequency characteristics (DC characteristics) while maintaining the good high-frequency characteristics of the operational amplifier OP1B.

It should be noted that the present invention is not limited to the above-described examples and can be modified as appropriate. For example, in the non-inverting amplifier circuit 1A, when the operational amplifier OP1A requires low-frequency characteristics in preference to high-frequency characteristics, the configuration illustrated in FIG. 2 can be adopted. Similarly, in the non-inverting amplifier circuit 1B, when the operational amplifier OP1B requires low-frequency characteristics in preference to high-frequency characteristics, the configuration illustrated in FIG. 6 can be adopted.

### INDUSTRIAL APPLICABILITY

According to the invention of the present application, even when the offset voltage SOF or the 1/f noise is generated in an operational amplifier, the offset voltage SOF or the 1/f noise can be sufficiently removed and the resulting signal can be output as an output signal. This enables the invention of the present application to be widely applied to such a non-inverting amplifier circuit.

### REFERENCE SIGNS LIST

1A, 1B Non-inverting amplifier circuit
C1A, C1B, C2A, C2B Capacitor
ISA, ISB Signal input part
OSA, OSB Signal output part
OP1A, OP1B, OP2A, OP2B Operational amplifier
P1 Connection point
R1A, R1B, R2A, R2B Resistor
SINA, SINB Input signal
SOUTA, SOUTB Output signal

## Claims

1. A non-inverting amplifier circuit that amplifies, in a non-inverting manner, an input signal input to a signal input part by a gain of 1 and outputs the amplified signal from a signal output part as an output signal, the non-inverting amplifier circuit comprising:
a 1A operational amplifier and a 2A operational amplifier,
wherein the 1A operational amplifier has a configuration in which a non-inverting input terminal is connected to the signal input part, an inverting input terminal is connected to an output terminal via a 1A resistor, and the output terminal is connected to the signal output part, and
the 2A operational amplifier has a configuration in which a non-inverting input terminal is connected to the output terminal of the 1A operational amplifier, an inverting input terminal is connected to the signal input part, and an output terminal is connected to the inverting input terminal of the 1A operational amplifier via a 2A resistor.

2. A non-inverting amplifier circuit that amplifies, in a non-inverting manner, an input signal input to a signal input part by a gain of 1 and outputs the amplified signal from a signal output part as an output signal, the non-inverting amplifier circuit comprising:
a 1A operational amplifier and a 2A operational amplifier,
wherein the 1A operational amplifier has a configuration in which a non-inverting input terminal is connected to the signal input part, an inverting input terminal is connected to an output terminal via a 1A resistor, and the output terminal is connected to the signal output part,
the 2A operational amplifier has a configuration in which a non-inverting input terminal is connected to the output terminal of the 1A operational amplifier, an inverting input terminal is connected to the signal input part via a 3A resistor and connected to an output terminal via a 1A capacitor, and the output terminal is connected to the inverting input terminal of the 1A operational amplifier via a 2A resistor,
the 2A resistor is configured by a series circuit of a 4A resistor connected to the inverting input terminal of the 1A operational amplifier and a 5A resistor connected to the output terminal of the 2A operational amplifier, and
a connection point between the 4A resistor and the 5A resistor and the non-inverting input terminal of the 1A operational amplifier are connected to each other by a 2A capacitor.

3. A non-inverting amplifier circuit that amplifies, in a non-inverting manner, an input signal input to a signal input part with a predetermined gain and outputs the amplified signal from a signal output part as an output signal, the non-inverting amplifier circuit comprising:
a 1B operational amplifier and a 2B operational amplifier,
wherein the 1B operational amplifier has a configuration in which an inverting input terminal is connected to an output terminal via a 1B resistor and connected to an intermediate potential via a 2B resistor, and the output terminal is connected to the signal output part, and
the 2B operational amplifier has a configuration in which a non-inverting input terminal is connected to the signal input part, an inverting input terminal is connected to the inverting input terminal of the 1B operational amplifier, and the output terminal is connected to the non-inverting input terminal of the 1B operational amplifier.

4. A non-inverting amplifier circuit that amplifies, in a non-inverting manner, an input signal input to a signal input part with a predetermined gain and outputs the amplified signal from a signal output part as an output signal, the non-inverting amplifier circuit comprising:
a 1B operational amplifier and a 2B operational amplifier,
wherein the 1B operational amplifier has a configuration in which a non-inverting input terminal is connected to the signal input part via a 1B capacitor, an inverting input terminal is connected to an output terminal via a 1B resistor and connected to an intermediate potential via a 2B resistor, and the output terminal is connected to the signal output part, and
the 2B operational amplifier has a configuration in which a non-inverting input terminal is connected to the signal input part via a 3B resistor, an inverting input terminal is connected to the inverting input terminal of the 1B operational amplifier via a 4B resistor and connected to an output terminal via a 2B capacitor, and an output terminal is connected to the non-inverting input terminal of the 1B operational amplifier via a 5B resistor.
